# FASCICULE DE BREVET EUROPEEN

(11) **EP 3 649 203 B1**
(45) Date de publication et mention de la délivrance du brevet: **26.10.2022**
(21) Numéro de dépôt: 18752551.4
(22) Date de dépôt: 02.07.2018
(51) Int. Cl.: C09D 133/14, C09J 133/14, H01L 31/048

(54) **MATÉRIAU ABSORBANT POUR LA PROTECTION DES DISPOSITIFS ÉLECTRONIQUES**
SAUGFÄHIGES MATERIAL ZUM SCHUTZ VON ELEKTRONISCHEN GERÄTEN
ABSORBENT MATERIAL FOR THE PROTECTION OF ELECTRONIC DEVICES

(30) Priorité: 04.07.2017 FR 1756307
(43) Date de publication de la demande: 13.05.2020
(73) Titulaire: Arkema France, 92700 Colombes (FR); Commissariat à l'Énergie Atomique et aux Énergies Alternatives, 75015 Paris (FR)
(72) Inventeur: TEYSSIER, Florian, 74000 Annecy (FR); HIDALGO, Manuel, 69530 Brignais (FR); CROS, Stéphane, 73000 Chambery (FR)
(74) Mandataire: Bandpay & Greuter
(86) Numéro de dépôt international: PCT/FR2018/051637
(87) Numéro de publication internationale: WO 2019/008259

(56) Documents cités:
- WO-A1-02/057385
- WO-A1-2014/193550
- JP-A- 2013 087 259

## Description

### DOMAINE DE L'INVENTION

La présente invention concerne une composition utile pour la protection des dispositifs électroniques et notamment optoélectroniques, en particulier contre les agressions potentielles d'origine physico-chimique.

### ARRIERE-PLAN TECHNIQUE

On entend par dispositif électronique soit un composant électronique unique, soit un ensemble de composants électroniques, le cas échéant disposé(s) sur un substrat, et susceptible(s) de remplir une ou des fonctions dans un circuit électronique.

De préférence, dans le cadre de l'invention, le dispositif électronique est plus particulièrement un dispositif optoélectronique, c'est-à-dire susceptible d'émettre, de détecter ou de contrôler un rayonnement électromagnétique.

Des exemples de dispositifs électroniques, ou le cas échéant optoélectroniques, concernés par la présente invention sont les transistors, les puces, les batteries, les cellules photovoltaïques, les diodes électroluminescentes (LED), les diodes électroluminescentes organiques (OLED), les capteurs, les actionneurs, les transformateurs et les détecteurs.

Les dispositifs électroniques et optoélectroniques sont utilisés et intégrés dans de nombreux appareils, équipements ou sous-ensembles électroniques et dans de nombreux objets et applications tels que les téléviseurs, les téléphones portables, les écrans rigides ou flexibles, les modules photovoltaïques à couches minces, les sources d'éclairage, les capteurs et convertisseurs d'énergie, etc.

Les dispositifs électroniques et optoélectroniques sont, très souvent, susceptibles de se dégrader, de s'abîmer, de perdre de leur efficacité ou de cesser de fonctionner suite à des agressions physico-chimiques provoquées par leur environnement proche, telles que la pénétration de liquides ou des gaz comme la vapeur d'eau et le dioxygène, les chocs, les contraintes thermomécaniques, notamment celles liées à des changements de température, au frottement, au contact avec des particules et autres corps étrangers, etc.

Pour éviter ces problèmes, il est connu de recouvrir ou encapsuler un dispositif électronique avec des couches protectrices solides, souvent associées sous la forme d'un empilement multicouches où chaque couche de l'ensemble a une fonction précise de protection du dispositif, notamment visà-vis des agents oxydants de l'atmosphère tels l'eau et le dioxygène.

En particulier, il est connu de laminer un film barrière aux gaz sur un dispositif électronique grâce à un adhésif. Le film barrière aux gaz est généralement composé d'un substrat polymère sur lequel est déposée une structure barrière aux gaz. La structure barrière aux gaz peut être de nature diverse mais elle comporte généralement une ou plusieurs couches denses inorganiques (typiquement constituées d'un oxyde métallique), en alternance le cas échéant avec des couches organiques.

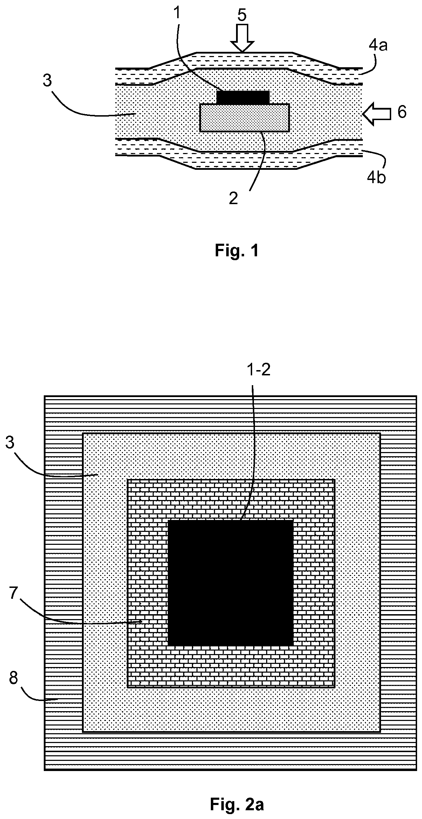

Toutefois, si le film barrière aux gaz assure une protection efficace visà-vis de la perméation orthogonale des gaz (à travers le film barrière), en revanche il existe aussi une perméation latérale des gaz, dans la couche d'adhésif et/ou à l'interface entre l'adhésif et le film barrière aux gaz. Ce phénomène est illustré sur la **figure 1** qui est décrite plus en détail ci-dessous.

Il existe donc un besoin d'améliorer la protection des dispositifs électroniques, notamment en réduisant ou en éliminant la perméation latérale des gaz dans les structures de protection.

Le document WO 02/057385 décrit un adhésif sensible à la pression hydro-désintégrable et son procédé de fabrication ; il n'aborde pas la problématique de la protection des dispositifs électroniques. D'autres documents relevents sont WO-A-2014/193550 et JP-A-231721.

### RESUME DE L'INVENTION

L'invention concerne en premier lieu l'utilisation selon la revendication 1 d'une composition comprenant un polymère P qui comprend des unités issues d'au moins un monomère insaturé cationique pour la protection d'un dispositif électronique.

Dans certains modes de réalisation, le monomère insaturé cationique est un monomère de formule (I) : 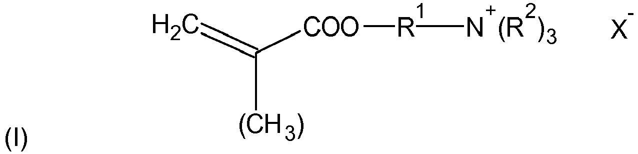 dans laquelle R¹ représente un groupement hydrocarboné divalent en C1 à C6, de préférence de C2 à C4, chaque groupe R² est indépendamment un groupement alkyle en C1 à C6, de préférence en C1 à C3, et X⁻ est un anion monovalent, de préférence un anion halogénure, et de préférence encore un anion bromure ou chlorure ; ledit monomère insaturé cationique étant de manière plus particulièrement préférée choisi parmi le chlorure d'acryloyloxyéthyltriméthylammonium et le chlorure de méthacryloyloxyéthyltriméthylammonium ; et ledit monomère insaturé cationique étant de manière encore plus préférée le chlorure d'acryloyloxyéthyltriméthylammonium.

Dans certains modes de réalisation, le polymère P est réticulé, et de préférence le polymère P comprend des unités issues du triméthylolpropane triacrylate, du N,N-méthylène-bis(méth)acrylamide, du N-méthylol(méth)acrylamide et/ou du (poly)éthylèneglycol-diméthacrylate.

Dans certains modes de réalisation, la proportion massique d'unités issues de monomères insaturés cationiques dans le polymère P vaut de 50 à 100 %, de préférence de 70 à 90 %

Dans certains modes de réalisation, le polymère P est un copolymère comprenant des unités issues d'au moins un monomère insaturé non ionique, de préférence choisi parmi les monomères (méth)acryliques, de préférence encore parmi les esters (méth)acryliques tels que le méthacrylate de méthyle et l'acrylate de butyle.

Dans certains modes de réalisation, la composition comprend en outre des particules d'un polymère P' non hydrosoluble, ledit polymère P' comprenant de préférence des unités issues d'un ou plusieurs monomères choisis parmi les monomères (méth)acryliques et notamment les esters (méth)acryliques tels que le méthacrylate de méthyle et l'acrylate de butyle, le styrène et ses dérivés, l'acétate de vinyle, l'acrylonitrile et les combinaisons de ceux-ci, la proportion relative pondérale de polymère P' par rapport à la somme du polymère P et du polymère P' étant de préférence de 10 à 60 %, de préférence encore de 20 à 40 %.

Dans certains modes de réalisation, la composition comprend une charge inorganique, de préférence choisie parmi le carbonate de calcium, l'oxyde de titane, les zéolithes, les boehmites, les polysilicates et les mélanges de ceux-ci, la teneur massique de la charge inorganique dans la composition étant de préférence de 1 à 50 %, de préférence encore de 2 à 20 %.

Dans certains modes de réalisation, la composition comprend un véhicule liquide, de préférence de l'eau et/ou un alcool, et de préférence dans une teneur massique de 2 à 50 %, de préférence encore de 5 à 35 %.

Dans certains modes de réalisation, l'utilisation ci-dessus est pour la protection d'un dispositif électronique contre les agressions d'origine physico-chimiques, et de préférence contre la dissolution, la corrosion et l'oxydation, notamment dues à l'eau ou au dioxygène.

Dans certains modes de réalisation, le dispositif électronique est choisi parmi les transistors, les puces, les batteries, les cellules photovoltaïques, les diodes électroluminescentes, les diodes électroluminescentes organiques, les capteurs, les actionneurs, les transformateurs et les photodétecteurs ; et de préférence est un dispositif optoélectronique, et de manière encore plus préférée une diode électroluminescente organique ou une cellule photovoltaïque organique.

Le dispositif électronique comprend au moins un composant électronique et éventuellement un substrat sur lequel le composant électronique est disposé, ainsi qu'une structure encapsulante, la composition étant présente sous forme de couche dans la structure encapsulante.

L'invention concerne également un dispositif électronique qui comprend au moins un composant électronique, éventuellement un substrat sur lequel le composant électronique est disposé, et une structure encapsulante comprenant au moins une couche de la composition décrite ci-dessus.

Dans certains modes de réalisation, la couche de la composition est disposée au-dessus et/ou en dessous du composant électronique et/ou du substrat éventuel, soit directement en contact avec le composant électronique et/ou le substrat, soit sur une couche intermédiaire, qui est de préférence une couche de planarisation et/ou une couche d'adhésif.

Dans certains modes de réalisation, la structure encapsulante comprend une ou plusieurs couches de la composition disposées à distance et autour, mais non au-dessus ou en dessous, du composant électronique et/ou du substrat.

Dans certains modes de réalisation, la structure encapsulante comprend au moins un film barrière aux gaz, de préférence deux films barrières aux gaz, de part et d'autre du composant électronique et le cas échéant du substrat, et au moins une couche de la composition disposée entre les deux films barrières aux gaz.

Dans certains modes de réalisation, le dispositif électronique est choisi parmi les transistors, les puces, les batteries, les cellules photovoltaïques, les diodes électroluminescentes, les diodes électroluminescentes organiques, les capteurs, les actionneurs, les transformateurs et les photodétecteurs ; et qui de préférence est un dispositif optoélectronique, et de manière encore plus préférée une diode électroluminescente organique ou une cellule photovoltaïque organique.

L'invention concerne également un appareil comprenant un ou plusieurs dispositifs électroniques tels que décrits ci-dessus, qui est de préférence choisi parmi les téléviseurs, les téléphones portables, les écrans rigides, les écrans flexibles, les modules photovoltaïques, les sources d'éclairage, les capteurs et les convertisseurs d'énergie.

L'invention concerne également un procédé de fabrication d'un dispositif électronique tel que décrit ci-dessus, comprenant la fourniture d'un composant électronique, éventuellement disposé sur un substrat, et la formation d'une structure encapsulante, comprenant au moins une étape de dépôt d'une couche de la composition décrite ci-dessus.

Dans certains modes de réalisation, le procédé comprend le dépôt d'une couche de la composition directement sur le composant électronique et/ou le substrat ; et/ou comprend le dépôt d'au moins une couche intermédiaire, qui est de préférence une couche de planarisation et/ou une couche d'adhésif, sur le composant électronique et/ou le substrat, puis le dépôt d'une couche de la composition sur cette couche intermédiaire.

Dans certains modes de réalisation, le procédé comprend :
- la fourniture d'un film barrière aux gaz, et la fixation de l'ensemble du composant électronique et du substrat éventuel sur celui-ci ; ou
- de préférence, la fourniture de deux films barrières aux gaz, et la fixation de l'ensemble du composant électronique et du substrat éventuel entre ceux-ci.

Dans certains modes de réalisation :
- une couche de la composition est déposée sur tout ou partie du composant électronique et/ou du substrat avant la fixation ; et/ou
- une couche de la composition est déposée sur tout ou partie du ou des films barrières aux gaz avant la fixation, cette couche de la composition étant de préférence déposée sur une ou plusieurs zones du ou des films barrières aux gaz non destinées à venir en contact avec le composant électronique et/ou le substrat.

Dans certains modes de réalisation, la composition comprend un véhicule liquide, de préférence de l'eau et/ou un alcool, et le procédé comprend une étape d'évaporation du véhicule liquide après le dépôt de couche de composition, à l'issue de laquelle la teneur massique en véhicule liquide dans la composition est de préférence de 2 à 50 %, de préférence encore de 5 à 35 %.

La présente invention permet de surmonter les inconvénients de l'état de la technique. Elle fournit une protection efficace des dispositifs électroniques, en permettant la mise en place d'une structure de protection dans laquelle en particulier la perméation latérale des gaz est réduite, voire éliminée.

Cela est accompli grâce à l'utilisation d'une composition comprenant un polymère noté P qui comprend des unités issues d'au moins un monomère insaturé cationique, tel que le chlorure d'acryloyloxyéthyltriméthylammonium par exemple. Sans vouloir être liés par une théorie, les présents inventeurs estiment que le polymère P, de par sa capacité d'absorption d'eau, permet de retarder voire de supprimer l'arrivée de la vapeur d'eau jusqu'au dispositif électronique. De plus, de manière surprenante, un effet de limitation de la perméation d'autres gaz tels que le dioxygène a été constaté. Cet effet peut être d'autant plus prononcé que la composition de l'invention a absorbé d'eau, ce qui conduit à un ralentissement progressif de la perméabilité à ces gaz au cours du temps.

En outre, le polymère P présente une bonne résistance au vieillissement notamment induit par la lumière.

La composition selon l'invention peut également facilement être appliquée sous forme de pâte ou de liquide puis séchée, ce qui constitue un mode d'application simple et peu onéreux. La synthèse du polymère P elle-même peut s'effectuer en milieu aqueux et/ou à température modérée, ce qui la rend simple et peu onéreuse.

L'application de la composition selon l'invention directement au-dessus du ou des composants électroniques du dispositif électronique, ou à distance de ceux-ci, offre une protection efficace du dispositif contre les agressions physico-chimiques dues aux gaz de l'environnement.

Avantageusement, la composition selon l'invention présente une transparence élevée, ce qui présente une utilité notamment pour les dispositifs optoélectroniques.

Avantageusement, la composition selon l'invention présente des propriétés de souplesse et de flexibilité élevées, et notamment plus élevées que les adhésifs classiques les plus efficaces des films barrières aux gaz, ce qui présente une utilité notamment pour les dispositifs électroniques flexibles.

### BREVE DESCRIPTION DES FIGURES

La **figure 1** est une vue en coupe schématique d'un dispositif électronique encapsulé selon l'invention.
La **figure 2a** est une vue en coupe schématique d'un dispositif électronique encapsulé selon l'invention.
La **figure 2b** est une autre vue en coupe schématique du même dispositif.

### DESCRIPTION DE MODES DE REALISATION DE L'INVENTION

L'invention est maintenant décrite plus en détail et de façon non limitative dans la description qui suit.

### Polymères P et P'

L'invention repose sur l'utilisation d'un polymère P. Le polymère P peut être un homopolymère ou un copolymère.

Le polymère P comporte des unités structurales (ou unités, ou unités de répétition, ou motifs) qui sont issues de (c'est-à-dire qui sont obtenues par polymérisation de) au moins un monomère insaturé cationique.

On entend par « *monomère cationique* » un monomère portant une charge nette positive. Le monomère cationique est associé à au moins un contre-ion négatif.

De préférence, le(s) monomère(s) insaturé(s) cationique(s) est (sont) hydrosoluble(s).

De préférence également, le polymère P lui-même est hydrosoluble.

On entend par « *hydrosoluble* » un composé soluble à une concentration d'au moins 100 g/L dans l'eau à 25°C.

Le polymère P peut comporter des unités issues d'un seul monomère insaturé cationique ou de plusieurs, de préférence d'un seul.

Il peut être constitué uniquement d'unités d'un ou plusieurs monomères insaturés cationiques. Alternativement, il peut comporter d'autres unités issues de monomères supplémentaires qui ne sont pas des monomères insaturés cationiques. Cette dernière variante peut permettre d'améliorer les propriétés mécaniques de la couche de composition de l'invention, et notamment de réduire les problèmes de fluage, d'améliorer les propriétés d'adhésion et de réduire la perméation.

La proportion pondérale d'unités issues de monomères insaturés cationiques dans le polymère P est par exemple d'au moins 50 %, de préférence encore d'au moins 60 %, ou d'au moins 70 %, ou d'au moins 80 %, ou d'au moins 85 %, ou d'au moins 90 %.

Des proportions dans des gammes de 50 à 100 %, de préférence de 70 à 90 %, sont particulièrement préférées.

Généralement, la synthèse du polymère P (ou du polymère P' décrit ci-dessous) est effectuée avec une conversion élevée, de préférence supérieure à 95 %, ou à 98 %, ou à 99 %. Par conséquent, on considère que la composition en unités du polymère P (ou du polymère P') est la même que celle du mélange de monomères qui ont été mis en œuvre pour la synthèse.

Toutefois, s'il existe un besoin de mesurer sur le polymère lui-même la proportion des unités polymérisées, on peut effectuer une analyse de résonance magnétique nucléaire (RMN) et/ou un dosage des contre-ions (par exemple par dosage des ions chlorures ou bromures) associés aux unités issues du monomère cationique décrit ci-dessus, après élimination des monomères non réagis.

Dans certains modes de réalisation, le ou les monomères insaturés cationiques sont des monomères (méth)acryliques, c'est-à-dire dérivés de l'acide (méth)acrylique, de formule (II) : 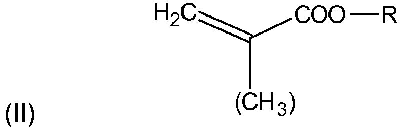 dans laquelle R représente un groupement pourvu d'une fonction cationique, associée à au moins un contre-ion négatif.

En particulier, le ou les monomères insaturés cationiques peuvent être de formule (I) : 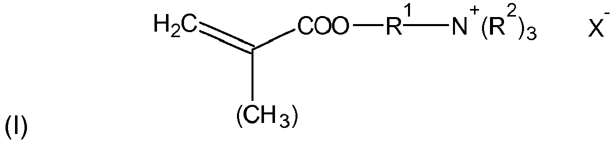 dans laquelle R¹ représente un groupement hydrocarboné divalent en C1 à C6, chaque groupe R² est indépendamment un groupement alkyle en C1 à C6 et X⁻ est un anion monovalent.

R¹ et R² peuvent être des groupements linéaires ou ramifiés, de préférence linéaires. Ils peuvent être substitués ou non, et de préférence ne sont pas substitués.

De préférence :
- R¹ représente un groupement hydrocarboné divalent en C1 à C5, de préférence encore en C2 à C4, ou en C2 à C3, et de préférence encore en C2 ; et/ou
- chaque groupe R² est indépendamment un groupement alkyle en C1 à C5, de préférence encore, en C1 à C4, ou en C1 à C3, ou en C1 à C2, et de préférence encore en C1 ; et/ou
- X⁻ est un anion halogénure, de préférence un ion chlorure ou bromure, et de préférence encore un ion chlorure.

Le chlorure d'acryloyloxyéthyltriméthylammonium et le chlorure de méthacryloyloxyéthyltriméthylammonium sont des exemples préférés de tels monomères, et tout particulièrement le chlorure d'acryloyloxyéthyltriméthylammonium.

Dans certains modes de réalisation, le polymère P est un copolymère qui comporte également des unités issues d'au moins un monomère insaturé non ionique. En particulier, le ou les monomères insaturés non ioniques peuvent être des monomères (méth)acryliques, c'est-à-dire des monomères d'acide acrylique ou d'acide méthacrylique ou des dérivés de ceux-ci, et notamment : les acrylates et méthacrylates d'alkyle, les acrylates et méthacrylates d'hydroxyalkyle, les amides issus de l'acide acrylique ou de l'acide méthacrylique, l'acrylonitrile, les acrylates et méthacrylates de glycidyle...

Dans certains modes de réalisation, le polymère P comprend des unités issues d'au moins un monomère insaturé non ionique hydrosoluble. Des exemples préférés sont l'acrylamide, l'acide acrylique, l'acide méthacrylique, leurs sels métalliques hydrosolubles, et leurs mélanges. Ces monomères peuvent permettre de contrôler la force ionique totale du polymère P et donc la reprise d'humidité et les propriétés adhésives de la composition qui le contient. Ces monomères sont généralement moins complexes à produire et donc moins onéreux que les monomères cationiques décrits ci-dessus.

Dans certains modes de réalisation, le polymère P comprend des unités issues d'au moins un monomère insaturé non ionique non hydrosoluble. Des exemples préférés sont les acrylates et méthacrylates d'alkyle dans lesquels le groupement alkyle est un groupement en C1 à C20, de préférence en C1 à C10, de préférence encore de C1 à C4 (et notamment le groupement méthyle), le styrène et ses dérivés, l'acétate de vinyle, et leurs mélanges. Ces unités peuvent permettre de réguler l'hydrodispersibilité du polymère P et d'améliorer ses propriétés mécaniques. En particulier, un tel polymère P peut présenter un caractère amphiphile qui facilite notamment la dispersion des charges qui lui sont mélangées.

Dans certains modes de réalisation préférés, le polymère P comprend des unités issues d'un ou plusieurs esters (méth)acryliques tels que par exemple le méthacrylate de méthyle et l'acrylate de butyle.

Le polymère P peut être réticulé ou non. La réticulation peut permettre d'améliorer la cohésion de la composition de l'invention, les propriétés d'adhésion, et de réduire la perméation, ainsi que les problèmes éventuels de fluage.

La réticulation peut être effectuée en ajoutant un réticulant lors de la polymérisation, de préférence dans une teneur de 0,01 à 1 % en poids par rapport au poids des (autres) monomères.

Des réticulants appropriés sont des monomères comportant au moins deux doubles liaisons ou un groupe fonctionnel réactif et une double liaison. Parmi ceux-ci, on peut citer le triméthylolpropane triacrylate, le N,N-méthylène-bis(méth)acrylamide, le N-méthylol(méth)acrylamide et le (poly)éthylèneglycol-diméthacrylate.

En outre, on peut utiliser des réticulants non polymérisables comportant au moins deux groupes réactifs capables de réagir avec les fonctions chimiques des unités monomères servant à la synthèse du polymère P. Parmi ceux-ci, on peut citer le (poly)éthylèneglycol-diglycidyléther, pouvant réagir par exemple avec des unités dérivées de l'acide acrylique, présentes dans le polymère P.

Des exemples préférés de polymère P sont les copolymères de chlorure d'acryloyloxyéthyltriméthylammonium, de méthacrylate de méthyle et optionnellement d'un monomère réticulant tel que le N,N-méthylène-bis(méth)acrylamide par exemple. Le polymère P comprend alors, en poids, de préférence de 50 à 99,99 %, de préférence encore de 60 à 95 % en poids, de préférence encore de 70 à 90 %, d'unités issues du chlorure d'acryloyloxyéthyltriméthylammonium ; de préférence de 0,01 à 1 % d'unités issues du monomère réticulant, le restant (le cas échéant) étant constitué d'unités issues du méthacrylate de méthyle.

Dans certains modes de réalisation, le polymère P peut être prévu en combinaison avec un polymère P' non hydrosoluble. Le polymère P' peut être un homopolymère ou un copolymère.

De préférence, le polymère P' comprend des unités issues d'au moins un monomère insaturé non ionique non hydrosoluble tel que décrit ci-dessus.

De préférence, le polymère P' comprend des unités issues d'un ou plusieurs monomères choisis parmi les monomères (méth)acryliques et notamment les esters (méth)acryliques tels que le méthacrylate de méthyle et l'acrylate de butyle, le styrène et ses dérivés, l'acétate de vinyle, l'acrylonitrile et les combinaisons de ceux-ci.

Le polymère P' peut également comprendre des unités issues de monomères insaturés non hydrosolubles fonctionnalisés, en particulier portant une fonction hydroxyle ou silane. De préférence, ces unités sont présentes dans une teneur de 0,1 à 10 % en poids par rapport au poids total du polymère P'. De telles unités sont susceptibles d'améliorer l'adhésion entre les polymères P et P'. Des monomères appropriés sont par exemple le méthacrylate de glycidyle, le gamma-méthacryloxy propyltriméthoxysilane ou le vinyle tri-isopropoxysilane.

Le polymère P' peut jouer le rôle de charge dans la composition, permettant d'améliorer les propriétés mécaniques de celle-ci.

En particulier, le polymère P' présente de préférence une température de transition vitreuse Tg supérieure à 30°C, et de préférence encore supérieure à 40°C, ou à 50°C, ou de manière plus particulièrement préférée à 60°C, ce qui garantit qu'il est sous forme rigide à température ambiante.

Ainsi, le polymère P' comprend des unités issues de monomères dont l'homopolymère correspondant possède une Tg supérieure à 30°C, et de préférence supérieure à 40°C, ou à 50°C, ou de manière plus particulièrement préférée à 60°C. Le polymère P' peut optionnellement comprendre en outre des unités issues de monomères dont l'homopolymère correspondant présente une Tg inférieure, si le polymère P' lui-même a une Tg suffisamment élevée.

Par exemple, le polymère P' peut être du polystyrène (Tg de 100°C environ), ou du polyméthacrylate de méthyle (Tg de 105°C environ), mais aussi un copolymère poly(méthacrylate de méthyle - acrylate de butyle) ; en effet, bien que la Tg de l'homopolymère de polyacrylate de butyle soit égale à -54°C environ, l'ajustement du rapport des unités issues des deux monomères respectifs permet d'obtenir une Tg suffisamment élevée pour le copolymère.

Les méthodes de mesure de la Tg des polymères incluent la calorimétrie différentielle à balayage (DSC), la volumétrie ou l'analyse mécanique dynamique (DMA).

De préférence, les monomères du polymère P' sont polymérisés en présence du polymère P, lors d'une deuxième étape de polymérisation. Ainsi, on obtient un mélange de polymères P et P' sous forme biphasique. De préférence, le polymère P' est présent sous forme de domaines (ou inclusions, ou particules) hydrophobes dans une matrice constituée par le polymère P. La taille moyenne Dv50 des domaines P' (qui peut être déterminée par granulométrie laser) est de préférence inférieure à 1 µm.

Dans certains modes de réalisation avantageux, le polymère P comprend des unités issues d'un monomère non ionique et non hydrosoluble, par exemple le méthacrylate de méthyle ; et le polymère P' est un homopolymère issu de ce même monomère, ou un copolymère comprenant des unités issues de ce même monomère. Cela facilite la synthèse du polymère P' à partir du polymère P et permet d'obtenir une dispersion fine et homogène des charges du polymère P' dans la matrice du polymère P.

La proportion pondérale de polymère P' par rapport à la somme des polymères P et P' peut être notamment : de 1 à 5 % ; ou de 5 à 10 % ; ou de 10 à 15 % ; ou de 15 à 20 % ; ou de 20 à 25 % ; ou de 25 à 30 % ; ou de 30 à 35 % ; ou de 35 à 40 % ; ou de 40 à 45 % ; ou de 45 à 50 % ; ou de 50 à 55 % ; ou de 55 à 60 % ; ou de 60 à 65 % ; ou de 65 à 70 % ; ou de 70 à 75 % ; ou de 75 à 80 %. Des proportions de 10 à 60 %, et en particulier de 20 à 40 %, peuvent être préférées.

### Procédé de préparation

Le polymère P peut être obtenu par un procédé de polymérisation radicalaire en une étape.

Le mélange du polymère P avec le polymère P' peut être obtenu par un procédé de polymérisation radicalaire en deux étapes (bien qu'il soit également possible, alternativement, d'effectuer un mélange du polymère P et du polymère P', préparés séparément).

De préférence, l'un et l'autre procédés sont effectués en l'absence de tensioactifs (les monomères cationiques ayant déjà une fonction tensioactive).

Le procédé de fabrication à une étape de polymérisation peut comprendre les opérations suivantes :
i) mise en solution ou dispersion dans un véhicule liquide (de préférence de l'eau déminéralisée) des monomères, éventuellement en présence d'un réticulant approprié ;
ii) polymérisation de ladite solution ou dispersion ; et
iii) éventuellement, ajustement de la teneur en véhicule liquide.

De préférence, la solution ou dispersion comprend de 10 à 80 % en poids de monomères.

Il peut être utile d'établir dans le réacteur un bullage d'azote, par exemple pendant 10 à 45 minutes avant la polymérisation. La température de polymérisation est avantageusement comprise entre 5 et 90°C, de préférence entre 40 et 85 °C.

Un amorceur radicalaire hydrosoluble peut être utilisé. Tout système d'amorçage par décomposition thermique, redox, photonique ou autre peut être utilisé, tant que sa cinétique de décomposition est compatible avec la température de polymérisation. On peut notamment ajouter de 0,005 à 2 %, et de préférence 0,01 à 0,75 % en poids d'amorceur par rapport au poids de monomères. De préférence, l'amorceur hydrosoluble est ajouté sous forme de solution aqueuse (par exemple à 0,5 à 2 % de concentration pondérale dans de l'eau déminéralisée). Il peut être ajouté une fois que le réacteur est porté à la température de réaction, ou avant. L'amorceur peut être introduit en une fois ou en plusieurs fois, par exemple une partie au début de la réaction, et une autre partie en cours de réaction (par exemple au bout de 30 à 45 minutes). Des amorceurs radicalaires hydrosolubles appropriés sont, par exemple, les persulfates de sodium, potassium et ammonium, l'eau oxygénée, l'hydroperoxyde de terbutyle, les sels de l'acide 4,4'-azo-bis(4-cyanopentanoïque), le di-chlorhydrate de 2,2'-azo-bis(2-amidinopropane) ou les couples redox persulfate / méthabisulfite de sodium, eau oxygénée / vitamine C, hydroperoxyde de terbutyle / acide érythorbique.

La fin de la réaction de polymérisation peut être détectée par le retour à la température visée après un pic exothermique ou, en condition isothermique, par l'extinction des besoins de refroidissement.

De préférence, on procède avant l'étape iii) à l'élimination des monomères résiduels (étape dite « *de cuisson* »). Celle-ci dure en général entre 1 et 8 heures. De préférence, la « *cuisson* » ne provoque pas une évaporation importante du véhicule liquide, elle se fait donc à une température inférieure à 100°C si la pression est atmosphérique et si le véhicule liquide est de l'eau.

Le produit peut ensuite être refroidi et retiré du réacteur pour stockage. Il peut se présenter sous la forme d'une solution ou dispersion transparente ou translucide concentrée à hauteur de 10 à 70 % en poids de polymère.

Le procédé de fabrication à deux étapes de polymérisation peut comprendre, entre les étapes ii) et iii) décrites ci-dessus, les étapes supplémentaires de :
iv) mise en solution ou dispersion dans le produit de l'étape ii) d'au moins un monomère nécessaire à la synthèse du polymère P', insaturé non hydrosoluble (par exemple dans une proportion de 1 à 75 % en poids par rapport au poids total de monomères) et ajustement de la teneur en véhicule liquide; et
v) polymérisation.

Il peut être utile d'établir dans le réacteur un bullage d'azote, par exemple pendant 10 à 45 minutes avant la polymérisation. La température de polymérisation est avantageusement comprise entre 5 et 90°C, de préférence entre 40 et 85°C.

Un amorceur de polymérisation peut être utilisé. On peut utiliser un amorceur radicalaire hydrosoluble ou liposoluble. Dans le cas d'un amorceur liposoluble, une partie des monomères non-hydrosolubles peut servir de solvant. De préférence, on utilise un amorceur radicalaire hydrosoluble.

Tout système d'amorçage par décomposition thermique, redox, photonique ou autre peut être utilisé, tant que sa cinétique de décomposition est compatible avec la température de polymérisation. On peut notamment ajouter de 0,005 à 2 %, et de préférence 0,01 à 0,75 % en poids d'amorceur par rapport au poids de monomères. De préférence, l'amorceur est ajouté sous forme de solution diluée (par exemple à 0,5 à 2 % de concentration pondérale dans de l'eau déminéralisée). Il peut être ajouté une fois que le réacteur est porté à la température de réaction, ou avant. L'amorceur peut être introduit en une fois ou en plusieurs fois, par exemple une partie au début de la réaction, et une autre partie en cours de réaction (par exemple au bout de 30 à 45 minutes).

On peut utiliser les mêmes amorceurs radicalaires hydrosolubles que pour la première étape de polymérisation. On peut également utiliser des amorceurs radicalaires liposolubles, seuls ou en combinaison avec un ou plusieurs amorceurs hydrosolubles. Parmi les amorceurs liposolubles, on peut citer notamment les peroxydes organiques comme le peroxyde de benzoyle, les composés azo comme le 2,2'-azo-bis-2-méthylbutyronitrile et les couples redox comme l'hydroperoxyde de cumène / chlorure de thionyle ou les couples redox mixtes (hydrosoluble-liposoluble) comme l'hydroperoxyde de cumène / méthabisulfite de sodium.

De préférence, on procède avant l'étape iii) à l'élimination des monomères résiduels (étape dite « *de cuisson* »). Celle-ci dure en général entre 1 et 8 heures. De préférence, la « *cuisson* » ne provoque pas une évaporation importante du véhicule liquide, elle se fait donc à une température inférieure à 100°C si la pression est atmosphérique et si le véhicule liquide est de l'eau.

Le produit peut être refroidi et retiré du réacteur pour stockage. Il se présente alors de préférence sous la forme d'une dispersion colloïdale diffusant la lumière (« *latex* »)*,* analogue à ce que l'on peut obtenir par des techniques de polymérisation en émulsion, avec un taux d'extrait sec (concentration de polymère) de préférence compris entre 10 et 60 %.

### Composition selon l'invention

La composition selon l'invention comprend le polymère P, éventuellement le polymère P' lorsqu'il est présent, et un véhicule liquide. Dans certains modes de réalisation, plusieurs polymères P différents, et/ou plusieurs polymères P' différents, sont présents. Toutefois, de préférence, un seul polymère P et le cas échéant un seul polymère P' sont présents.

Dans certains modes de réalisation, le véhicule liquide est de l'eau (par exemple de l'eau déminéralisée, ou une solution aqueuse).

Dans certains modes de réalisation, le véhicule liquide est un alcool, notamment choisi parmi l'éthanol, le méthanol, les diols et polyols tels que les glycols et polyglycols, le glycérol, les éthers et esters de (poly)glycols et l'isosorbide. L'éthylène glycol peut être mentionné à titre d'exemple.

Des mélanges d'eau et d'alcool(s) peuvent également être employés.

Avant application de la composition sur une surface, le véhicule est de préférence présent dans la composition dans une proportion massique de 30 à 99 %, de préférence encore de 40 à 90 %.

Le véhicule liquide, de préférence l'eau, peut être directement issu du procédé de préparation du polymère P (et éventuellement du polymère P'). Facultativement, la teneur en eau peut être ajustée, notamment par évaporation, jusqu'à la valeur souhaitée.

Alternativement, le véhicule liquide de la composition peut être différent de celui utilisé au cours de la polymérisation. En particulier, si le véhicule liquide utilisé au cours de la polymérisation est de l'eau, il est possible de remplacer l'eau par un alcool ou par un mélange eau / alcool lors de la fabrication de la composition.

Après application de la composition sur une surface, le véhicule liquide est de préférence présent dans la composition dans une proportion massique de 1 à 60 %, de préférence encore de 2 à 50 %, de préférence encore de 5 à 35 %. L'ajustement éventuel de la teneur en véhicule liquide après application sur une surface est décrit plus en détail ci-dessous. La mesure de la teneur en véhicule liquide dans une couche de composition sur une surface peut être effectuée par analyse gravimétrique (en comparant la masse de la couche à celle de la composition initialement appliquée, et compte tenu de la teneur en véhicule liquide de cette composition initialement appliquée). Alternativement, on peut utiliser une mesure de résistivité électrique ou de capacité électrique ou une analyse infrarouge.

La composition peut également comprendre une charge différente du polymère P', notamment (mais pas exclusivement) en l'absence de polymère P', ou lorsque la teneur du polymère P' est faible. De préférence, il s'agit d'une charge inorganique.

La charge inorganique peut notamment être choisie parmi le carbonate de calcium, l'oxyde de titane, les zéolithes, les boehmites, les polysilicates et les mélanges de ceux-ci, la teneur massique de la charge inorganique dans la composition étant de préférence de 1 à 50 %, de préférence encore de 2 à 20 %.

La taille moyenne Dv50 des particules de la charge (qui peut être déterminée par granulométrie laser) est de préférence inférieure à 1 µm.

La charge peut être introduite au cours de la synthèse du polymère P (et éventuellement du polymère P'), ou après la synthèse par des moyens dispersifs adéquats comprenant par exemple une agitation vigoureuse assistée ou non par des ultrasons.

### Protection des dispositifs électroniques

La composition selon l'invention est utilisée pour la protection d'un dispositif électronique.

Le dispositif électronique comporte avantageusement un ou plusieurs composants électroniques disposés sur un substrat. Les composants électroniques peuvent comprendre des couches de matériau conducteur, de matériau semi-conducteur et autres. Ils sont de préférence sur une seule face du substrat mais dans certains modes de réalisation ils peuvent être sur les deux faces du substrat.

Le substrat peut notamment être une feuille de métal, de silicium, de verre, de quartz, ou de polymère, et de préférence, s'agissant des dispositifs flexibles, une feuille de polyéthylène téréphtalate (PET) ou de polyéthylène naphtalate (PEN).

L'épaisseur du substrat peut de préférence varier de 3 µm à 4 mm, plus particulièrement de 12 µm à 200 µm lorsqu'il est souhaité que le dispositif soit flexible.

L'épaisseur maximale des composants électroniques au-dessus du substrat peut notamment varier de 10 nm à 1 mm, de préférence de 20 nm à 500 µm.

Le dispositif électronique comprend également avantageusement une structure encapsulante. Par « *structure encapsulante* », on entend une structure comportant une couche ou un empilement de couches (ou films) recouvrant les composants électroniques et tout ou partie du substrat. De préférence, cette structure encapsulante recouvre en totalité les composants électroniques et le substrat, de part et d'autre de celui-ci.

Avantageusement, la structure encapsulante comporte au moins une couche de composition de l'invention.

La (ou chaque) couche de composition de l'invention peut en particulier avoir une épaisseur de 1 µm à 1 mm, de préférence de 2 µm à 400 µm, de préférence encore de 5 à 150 µm, de préférence encore de 10 à 100 µm, de préférence encore de 20 à 70 µm.

La structure encapsulante peut comprendre une paroi en verre, éventuellement associée à une couche polymère (notamment pour les dispositifs électroniques rigides), ou deux telles parois en verre disposées de part et d'autre de l'ensemble formé par les composants électroniques et le substrat.

Alternativement, et de préférence, la structure encapsulante comprend au moins un film barrière aux gaz, et de préférence encore deux films barrières aux gaz, disposés de part et d'autre de l'ensemble formé par les composants électroniques et le substrat.

Un film barrière aux gaz est un film qui est défini ici comme présentant un flux orthogonal de transmission de la vapeur d'eau (WVTR) inférieur à 10⁻¹ g.m⁻².j⁻¹, de préférence inférieur à 10⁻² g.m⁻².j⁻¹, de préférence encore inférieur à 10⁻³ g.m⁻².j⁻¹, de préférence encore inférieur à 10⁻⁴ g.m⁻².j⁻¹, de préférence encore inférieur à 10⁻⁵ g.m⁻².j⁻¹.

Ce flux orthogonal de transmission de la vapeur d'eau peut être mesuré de la manière suivante : une pression partielle donnée en gaz cible (vapeur d'eau) est maintenue sur la face amont de l'échantillon. La concentration en gaz cible dépend des standards définis dans des normes (une hygrométrie de 85 % et une température de 38°C pour la mesure de l'eau par exemple selon les normes ASTM D3985-95 et F1249-90). La face aval de l'échantillon est maintenue à une pression partielle en perméant nulle, soit par un flux de gaz neutre (azote) qui transporte le gaz ayant diffusé dans l'échantillon jusqu'à un capteur, soit par le vide. La mesure est effectuée en obtenant un flux constant (régime stationnaire qui suit le régime transitoire).

Le film barrière aux gaz est de préférence une structure multicouches (formée préalablement), comportant un support ou substrat polymère et une ou plusieurs couches barrières aux gaz, avec optionnellement une ou des couches d'intercalation. Chaque couche barrière aux gaz est de préférence une couche inorganique.

Le film barrière aux gaz comporte avantageusement une ou plusieurs dyades successives d'une couche inorganique (dense), par exemple de type oxyde ou nitrure métallique ; et d'une couche polymère d'intercalation (moins dense) ayant de préférence une épaisseur de quelques microns, par exemple de 1 à 25 µm, notamment de 2 à 5 µm ; et enfin un substrat polymère se trouvant, après assemblage, en position la plus externe de l'empilement et servant également de couche protectrice la plus externe par rapport au composant électronique.

Chaque couche inorganique peut avoir une épaisseur de l'ordre de quelques centaines de nanomètres, donc par exemple de 50 nm à 1 µm et plus préférentiellement de 100 nm à 700 nm, ou de 200 à 500 nm, notamment en cas de dépôt par PECVD (« *plasma-enhanced, chemical vapour deposition* » ou dépôt chimique en phase vapeur assisté par plasma) ou PVD *(« physical vapor deposition* » ou dépôt physique par phase vapeur), par exemple pour du SiO₂. Elle peut être d'épaisseur inférieure, de l'ordre de quelques dizaines de nanomètres, donc par exemple de 10 à 100 nm, et plus préférentiellement de 15 à 50 nm et notamment de 20 à 40 nm, en cas de dépôt par ALD (« *atomic layer deposition* » ou dépôt de couches atomiques), par exemple pour les dépôts d'Al₂O₃, ou de ZnO, ou de ZnO:Al, ou de SiO₂, ou de TiO₂, ou de Ta₂O5, ou de HfO₂, ou de SnO₂. Le substrat polymère du film barrière aux gaz peut être par exemple en polyéthylène téréphtalate (PET) ou en polyéthylène naphtalate (PEN).

Chaque couche de polymère d'intercalation peut être par exemple en polymère organique, par exemple de nature chimique acrylique, ou en matériau hybride organique / inorganique, par exemple tel que commercialisé sous le nom Ormocer^{®}.

A la place de l'alternance des couches inorganiques et couches polymères d'intercalation, on peut utiliser une structure multicouches hybride présentant une variation continue de la composition entre une forme inorganique SiOₓN_{y} et une forme hybride SiOₓC_{y} (cette structure pouvant être obtenue par dépôt PECVD).

Alternativement encore, la structure multicouches peut comprendre une couche de verre flexible.

Alternativement, il est possible, dans certaines applications, de ne pas utiliser de film barrière aux gaz dans la structure encapsulante. Cela est particulièrement le cas, grâce à l'effet retardateur de la perméation d'eau de la couche de composition de l'invention. Ainsi, cet effet retardateur, en plus de la réversibilité de l'absorption (absorption/désorption) d'eau de la couche de l'invention, selon les conditions réelles d'humidité (notamment en applications d'intérieur) peut conduire avantageusement à l'omission dans la structure encapsulante, du film barrière aux gaz.

Au sein de la structure encapsulante, la composition peut être présente sous la forme d'une ou plusieurs couches soit au-dessus et/ou en dessous du ou des composants électroniques (et du substrat), soit autour et à distance de ceux-ci (ou, au moins, des composants électroniques).

A la fois le substrat et la structure multicouches définissent une direction transversale, selon l'épaisseur du substrat et des couches de la structure multicouches. Autrement dit, la direction transversale est la direction orthogonale au plan du substrat. Les termes « *au-dessus* » et « *en dessous* » du composant électronique signifient d'un côté ou de l'autre du composant électronique, selon cette direction transversale. Le terme « *autour »* du composant électronique s'entend comme désignant un positionnement qui n'est ni au-dessus, ni en dessous de ce composant électronique.

Lorsque la composition est appliquée à distance des composants électroniques, la distance entre la couche de composition et les composants électroniques (dans une direction orthogonale à la direction transversale mentionnée ci-dessus) est de préférence supérieure ou égale à 100 nm, ou à 1 µm, ou à 10 µm, ou à 100 µm.

Selon une première variante, au moins une couche de composition de l'invention peut recouvrir (c'est-à-dire être disposée au-dessus de et/ou en dessous de) tout ou partie des composants électroniques, et éventuellement tout ou partie du substrat. De préférence, la couche recouvre au moins une partie du substrat et au moins une partie des composants électroniques. De préférence, encore, elle recouvre en totalité les composants électroniques. De préférence, encore, elle recouvre en totalité les composants électroniques et le substrat. Elle peut recouvrir une seule des deux faces du substrat (de manière préférée la face qui comporte les composants électroniques), en tout ou en partie, ou alternativement les deux faces du substrat, en tout ou en partie. De préférence, elle recouvre la totalité des composants électroniques et du substrat, sur ses deux faces.

Ainsi, en faisant référence à la **figure 1**, un composant électronique selon l'invention peut comprendre un substrat 2 tel que décrit ci-dessus, sur lequel est disposé au moins un composant électronique 1. La direction transversale correspond à l'orientation de la hauteur dans le schéma.

La structure encapsulante comprend :
- une couche de composition selon l'invention 3 qui peut recouvrir l'ensemble du composant électronique 1 et du substrat 2, sur ses deux faces, et enrober complètement l'ensemble du composant électronique 1 et du substrat 2 ; et
- un premier film barrière aux gaz 4a et un deuxième film barrière aux gaz 4b disposés sur la couche de composition de l'invention, de part et d'autre de celle-ci.

Les films barrières aux gaz 4a, 4b offrent une résistance élevée à la perméation des gaz 5 perpendiculaire au substrat. En revanche, s'agissant de la perméation des gaz 6 latérale, c'est-à-dire essentiellement parallèlement au substrat, les propriétés de la couche de composition selon l'invention sont déterminantes.

De manière générale, lorsque l'on indique que la couche de composition selon l'invention est disposée au-dessus ou en dessous de, ou recouvre, le substrat et/ou le composant électronique, deux possibilités sont envisagées :
- soit la couche de composition selon l'invention est directement en contact avec le substrat et/ou le composant électronique (selon les cas) ;
- soit la couche de composition selon l'invention n'est pas directement en contact avec le substrat et/ou le composant électronique (selon les cas), du fait de la présence d'une ou plusieurs couches intermédiaires entre le substrat et/ou le composant électronique (selon les cas) d'une part et la couche de composition selon l'invention d'autre part.

Dans ce deuxième cas, la couche de composition selon l'invention peut être notamment disposée sur et directement en contact avec une couche intermédiaire, elle-même disposée sur et directement en contact avec le substrat et/ou le composant électronique.

La présence d'une couche intermédiaire permet d'éviter tout contact direct entre les composants électroniques et la couche de composition selon l'invention, ce qui peut être nécessaire lorsque ces composants sont susceptibles d'être détériorés par un contact direct avec la couche de composition selon l'invention, que ce soit du fait d'une incompatibilité de nature chimique, ou du fait que la couche de composition de l'invention a tendance à se charger en eau progressivement, et peut donc devenir de ce fait incompatible avec les composants électroniques.

La couche intermédiaire peut être une couche planarisante ou de planarisation, c'est-à-dire une couche réduisant la rugosité de surface.

La couche intermédiaire présente de préférence une épaisseur de 1 nm à 50 µm, de préférence encore de 100 nm à 20 µm. Elle présente de préférence une rugosité Ra inférieure ou égale à 20 nm, et plus particulièrement inférieure ou égale à 10 nm et de manière encore plus préférée, inférieure ou égale à 7 nm. La rugosité de surface peut être déterminée par une mesure de topographie de surface avec un profilomètre de type alpha-step IQ.

La couche intermédiaire, notamment lorsqu'il s'agit d'une couche planarisante, peut en particulier être une couche de polymère comprenant des unités de répétition issues du fluorure de vinylidène (VDF), et le cas échéant d'un ou plusieurs autres monomères. L'hexafluoropropène (HFP) est un comonomère préféré. Ainsi, le polymère fluoré utilisé dans la couche planarisante est de préférence un copolymère P(VDF-HFP). La proportion molaire d'unités de répétition issues de l'HFP vaut de préférence de 2 à 50 %, notamment de 5 à 40 %.

Alternativement, et toujours dans le deuxième cas, la couche de la composition selon l'invention peut être disposée sur et directement en contact avec une couche d'adhésif, elle-même disposée sur et directement en contact avec le substrat et/ou le composant électronique.

Alternativement, et toujours dans le deuxième cas, la couche de la composition selon l'invention peut être disposée sur et directement en contact avec une couche d'adhésif, elle-même disposée sur et directement en contact avec une couche planarisante (telle que décrite ci-dessus), elle-même disposée sur et directement en contact avec le substrat et/ou le composant électronique. Dans cette éventualité, deux couches intermédiaires superposées sont disposées entre le substrat et/ou le composant électronique et la couche de la composition selon l'invention, à savoir une couche planarisante, et une couche d'adhésif.

Que ce soit dans le premier cas ou dans le deuxième cas, le film barrière aux gaz qui surmonte la couche de composition de l'invention peut être directement en contact avec celle-ci. Alternativement, une ou plusieurs couches intermédiaires, et notamment une couche d'adhésif peuvent être prévues entre la couche de composition de l'invention et le film barrière aux gaz.

Lorsqu'aucune couche d'adhésif n'est utilisée, la composition selon l'invention remplit elle-même la fonction adhésive requise pour l'adhésion aux couches ou structures adjacentes (notamment film barrière aux gaz, composant électronique et substrat, et/ou couche de planarisation).

Selon une deuxième variante, aucune couche de composition de l'invention ne recouvre (c'est-à-dire n'est disposée au-dessus de et/ou en dessous de) tout ou partie des composants électroniques. Dans ce cas, il est préféré qu'au moins une couche de composition de l'invention soit disposée autour des composants électroniques, à distance de ceux-ci, et de préférence entoure complètement l'ensemble des composants électroniques ou entoure chaque composant électronique individuel (selon le plan orthogonal à la direction transversale).

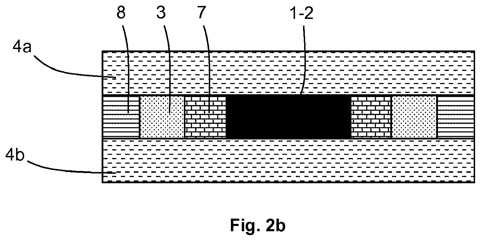

Un exemple de cette deuxième variante est illustré aux **figures 2a** et **2b****,** qui sont deux vues schématiques en coupe d'un dispositif électronique muni d'une structure d'encapsulation, respectivement selon un plan orthogonal à la direction transversale, et selon un plan comprenant la direction transversale (cette direction transversale correspondant à l'orientation de la hauteur dans la **figure 2b**).

Dans l'exemple représenté, le composant électronique 1 et son substrat 2 (qui sont illustrés schématiquement sous la forme d'une zone unique sur les figures) sont recouverts, de part et d'autre, d'un premier film barrière aux gaz 4a et d'un deuxième film barrière aux gaz 4b. Entre les deux films barrières aux gaz 4a, 4b, et autour du composant électronique 1 et de son substrat 2, sont disposés successivement, de manière concentrique : une zone intermédiaire 7, et une zone 3 comprenant une couche de composition selon l'invention.

Bien que cela ne soit pas représenté sur les figures, il est possible de prévoir un enchaînement de deux ou de plus de deux paires successives de zone intermédiaire 7 et de zone 3 comprenant une couche de composition selon l'invention, de manière concentrique, autour du composant électronique 1 et de son substrat 2, et entre les films barrières aux gaz 4a, 4b. Un tel enchaînement peut permettre d'améliorer encore la résistance à la perméation latérale.

La ou chaque zone intermédiaire 7 peut comporter une couche d'adhésif qui est différent de la composition de l'invention. Alternativement, la ou chaque zone intermédiaire 7 peut être une zone vide et/ou remplie d'un gaz, notamment de l'air ou un gaz inerte, ou encore comporter un matériau polymère.

L'ensemble de la ou des paires de zone intermédiaire 7 et de zone 3 comprenant une couche de composition selon l'invention peut être optionnellement entouré par une zone extrémale 8, toujours entre les films barrières aux gaz 4a, 4b, qui peut par exemple comporter une couche d'adhésif qui est différent de la composition de l'invention. Cette zone extrémale peut être également désignée comme une zone de scellement périphérique, ou « *edge-sealing* » selon le terme usité en langue anglaise.

Bien que cela ne soit pas illustré, il est entendu qu'une ou des couches de planarisation, et/ou une ou des couches d'adhésif, telles que décrites ci-dessus, peuvent être prévues entre d'une part le composant électronique 1 et son substrat 2 et éventuellement les zones intermédiaires 7, zones 3 comprenant une couche de composition selon l'invention et/ou zone extrémale 8, et d'autre part un ou chaque film barrière aux gaz 4a, 4b.

Dans l'ensemble de ce qui précède, chaque couche d'adhésif différent de la composition selon l'invention peut être notamment une couche d'un adhésif sensible à la pression ou un adhésif liquide photo-réticulable ou thermo-réticulable, de préférence un adhésif acrylique photo-réticulable. On peut utiliser également un film de matériau thermofusible tel qu'un copolymère d'éthylène et d'acétate de vinyle (EVA) ou un adhésif liquide tel qu'un silicone. Une post-réticulation thermique peut être employée.

L'ensemble de l'encapsulation du dispositif électronique décrite ici peut notamment être de type HB (haute barrière) ou UHB (ultra-haute barrière). Une structure HB présente un flux orthogonal de transmission de la vapeur d'eau de 10⁻³ à 10⁻⁵ g.m⁻².j⁻¹, et une structure UHB présente un flux de transmission de la vapeur d'eau inférieure à 10⁻⁵ g.m⁻².j⁻¹.

De préférence, soit la partie de la structure d'encapsulation située au-dessus et/ou en dessous des composants électroniques est transparente ; soit l'ensemble de la structure d'encapsulation est transparente.

Un capot, de préférence transparent, par exemple en verre, peut être disposé au-dessus du dispositif électronique muni de sa structure d'encapsulation telle que décrite ci-dessous.

Le dispositif électronique comprend également des éléments de connectique, non représentés sur les figures. Ces éléments de connectique traversent la structure encapsulante, généralement dans une direction orthogonale à la direction transversale. Si nécessaire, un adhésif peut être appliqué autour des éléments de connectique pour améliorer leur conformation à la structure encapsulante.

Pour fabriquer les différentes structures encapsulantes décrites ci-dessus, la ou chaque couche de composition selon l'invention, ainsi que la ou les éventuelles couches additionnelles (couche d'adhésif, couche de planarisation...) peuvent être déposées successivement :
- sur l'ensemble formé par le substrat et le(s) composant(s) électronique(s) ; et/ou
- sur le ou les films barrières.

Le dépôt de ces couches peut être effectué par des moyens discrets ou continus. On peut utiliser notamment le dépôt par rotation, l'atomisation, la sérigraphie, la flexographie, le dépôt par tête à fente, le dépôt par tire-film, l'impression à jet d'encre, l'immersion. Les méthodes d'étalement préférées sont le dépôt par rotation, par tête à fente ou par tire-film de type « *Doctor Blade* » (sans contact avec le dispositif).

La viscosité de la composition de l'invention peut être adaptée en fonction de la technique de dépôt et peut être contrôlée notamment par la concentration de polymère(s) dans la composition.

Après dépôt de la couche de composition de l'invention, on peut procéder à un séchage de sorte à faire évaporer au moins partiellement le véhicule liquide, et en particulier lorsque le dépôt est effectué (directement ou non sur un film barrière aux gaz). Le séchage peut notamment être effectué en appliquant un chauffage et/ou sous vide. Par exemple, on peut procéder à une première phase de séchage sous atmosphère ambiante (typiquement à 20-30°C et 20-70 % d'humidité relative) puis une deuxième phase de séchage en chauffant (par exemple à une température de 70°C), sous vide

Avantageusement, on procède à un séchage partiel, ou à un séchage total suivi d'une étape de reprise partielle de véhicule liquide, notamment d'eau. Lorsque le véhicule liquide est de l'eau, l'étape de reprise partielle peut s'effectuer en plaçant le produit sec sous atmosphère ambiante (typiquement à 20-30°C et 20-70 % d'humidité relative) ou dans une enceinte climatique à atmosphère contrôlée (par exemple à une température de 50 à 90°C, de préférence de 65 à 85°C, et à une humidité relative de 70 à 95 %, par exemple de 85 %).

De préférence, la teneur en véhicule liquide dans la composition après dépôt, et éventuellement séchage / reprise partielle, est de 2 à 50 % en poids, de préférence encore de 5 à 35 % en poids.

La présence de véhicule liquide résiduel (en particulier d'eau résiduelle) permet notamment d'améliorer les propriétés adhésives et de réduire les propriétés de perméation de la couche de composition de l'invention.

Le ou les films barrières aux gaz (avec éventuellement des couches additionnelles déposées sur ceux-ci, comme décrit ci-dessus), peuvent être laminés avec l'ensemble formé par le ou les composants électroniques et le substrat (avec éventuellement des couches additionnelles déposées sur ceux-ci, comme décrit ci-dessus), notamment par un procédé rouleau à rouleau ou sous vide.

### EXEMPLES

Les exemples suivants illustrent l'invention sans la limiter.

### Exemple 1 - fabrication d'un polymère monophasique réticulé

On charge 316 g d'eau déminéralisée dans un réacteur de polymérisation équipé d'une double enveloppe permettant la circulation d'un fluide caloporteur pour chauffer/refroidir le système, d'un piquage permettant l'introduction d'azote gazeux pour chasser l'oxygène, d'un agitateur couplé à un moteur permettant de tourner à vitesse variable, d'une entrée permettant l'ajout de matière et d'une sortie de vapeurs liée à un système de condensation/reflux.

Un balayage d'azote est appliqué, le milieu réactionnel est porté à 70°C et agité à 300 tours/min. On introduit successivement 125 g d'une solution aqueuse de chlorure d'acryloyloxyéthyltriméthylammonium (80% en masse de matière active), 17,8 g de méthacrylate de méthyle et 0,64 g de N,N'-méthylènebis(acrylamide) Après 30 min de dégazage, une première solution d'amorçage est injectée dans le milieu réactionnel, soit 0,24 g de persulfate de potassium en solution dans 18 g d'eau déminéralisée. Après la fin de l'exothermie de la réaction, la température de la double enveloppe est modifiée de façon à ce que le milieu réactionnel soit à 80°C. 30 min après l'addition de la solution d'amorçage, on renouvelle la même addition de 0,24 g de persulfate de potassium en solution dans 18 g d'eau déminéralisée.

Une cuisson de 3 h est effectuée en maintenant le milieu réactionnel à 80°C avant un refroidissement à température ambiante. Le réacteur est alors vidangé. La solution obtenue se présente sous la forme d'une solution visqueuse transparente légèrement jaune dont l'extrait à sec est mesuré à 25,1% en masse.

### Exemple 2 - fabrication d'un polymère biphasique

Le protocole de l'exemple 1 est répété, avec les différences suivantes :
- monomères introduits : 125 g d'une solution aqueuse de chlorure d'acryloyloxyéthyltriméthylammonium (80% en masse de matière active), 17,7 g de méthacrylate de méthyle et 0,64 g de N,N'-méthylènebis(acrylamide) ;
- cuisson de 4 h au lieu de 3 h.

Après la cuisson, au lieu de procéder au refroidissement, on additionne successivement 328 g d'eau déminéralisée et 58,5 g de méthacrylate de méthyle et le milieu réactionnel est à nouveau placé sous balayage d'azote durant 30 min. A la fin de cette période on ajoute à nouveau une solution d'amorçage constituée de 0,30 g de persulfate de potassium dans 22,5 g d'eau. Une nouvelle exothermie est observée ainsi qu'une perte de la transparence du milieu. On renouvelle cette addition après 45 min avec 0,30 g de persulfate de potassium dans 22,5 g d'eau. Le milieu réactionnel est maintenu 2h30 toujours à 80°C avant d'être refroidi à température ambiante. Le réacteur est alors vidangé. La solution obtenue se présente sous la forme d'un latex blanc dont l'extrait à sec est mesuré à 19,1 % en masse.

### Exemple 3 - fabrication d'un polymère monophasique non réticulé

Le protocole de l'exemple 1 est répété, avec les différences suivantes :
- monomères introduits : 135 g d'une solution aqueuse de chlorure d'acryloyloxyéthyltriméthylammonium (80 % en masse de matière active) et 12 g de méthacrylate de méthyle ;
- deuxième addition de la solution d'amorçage 45 min après la première.

La solution obtenue se présente sous la forme d'une solution faiblement visqueuse transparente légèrement jaune dont l'extrait à sec est mesuré à 28,1% en masse.

### Exemple 4 - dépôt sur un substrat (polymères des exemples 1, 2 et 3)

A l'aide d'une seringue, on prélève 3 mL de solution de polymère de l'exemple 1, que l'on dépose sur un échantillon de substrat PET (8 cm × 8 cm × 50 µm) préalablement traité UV/ozone pendant 10 min. La solution est étalée à l'aide d'un tire-film (méthode dite « *Doctor Blade* ») dont la vitesse de déplacement est de 25 mm/s. Le matériau résultant est placé dans une étuve à 70°C sous vide pendant 2 h pour séchage.

La dispersion liquide (latex) de l'exemple 2 est concentrée par simple chauffage jusqu'à obtenir un extrait à sec de 44 % en masse. A l'aide d'une seringue munie d'un filtre à 5 µm, on prélève 3 mL de la dispersion que l'on dépose au centre d'un échantillon de substrat PET (8 cm × 8 cm × 50 µm) préalablement traité UV/ozone pendant 10 min. L'échantillon est placé en rotation à 1000 tours/min ; cette vitesse est atteinte au bout de 7 s puis maintenue durant 23 s. Le matériau résultant est placé dans une étuve à 70°C sous vide pendant 2 h pour séchage.

On chauffe à 85°C la solution de l'exemple 3 obtenue en fin de synthèse pour évaporer l'eau qui sert de solvant. Le solide ainsi obtenu est placé 2 h sous vide à 70°C avant une addition d'éthylène glycol de façon à obtenir un mélange contenant 48 % en masse de solide. A l'aide d'une seringue, on prélève 3 mL de la solution dans l'éthylène glycol que l'on dépose sur un échantillon de substrat PET (8 cm × 8 cm × 50 µm) préalablement traité UV/ozone pendant 10 min. La solution est étalée à l'aide d'un tire-film (méthode dite « *Doctor Blade* ») dont la vitesse de déplacement est de 35 mm/s. Le matériau résultant est alors immédiatement recouvert d'un second substrat PET ayant les mêmes dimensions que le précédent.

### Exemple 5 - mesures de perméation (polymère de l'exemple 1)

On étudie la perméabilité d'un système composé d'un substrat PET d'épaisseur 50 µm sur lequel a été déposée une épaisseur de 62 µm du polymère de l'exemple 1 qui a été séchée et recouverte d'un autre substrat PET de 50 µm. Cet échantillon est placé dans un perméamètre permettant d'avoir accès à la valeur du flux de transmission de la vapeur d'eau (WVTR) et de la durée transitoire (durée observée avant l'atteinte de l'équilibre, notée TL pour « *time lag* »)*.*

Par ailleurs, on suit l'évolution du coefficient de diffusion entre un état initial des échantillons décrits précédemment (coefficient de diffusion Dsec à l'état sec) et l'état final lors de la stabilisation du WVTR (coefficient de diffusion Dhum à l'état humide).

Une comparaison est effectuée avec un système substrat PET / adhésif comparatif / substrat PET. L'adhésif comparatif est l'adhésif commercial DELO^{®} Katiobond^{®} LP655, qui est un adhésif barrière de référence. Les deux substrats PET ont chacun une épaisseur de 50 µm et la couche d'adhésif a une épaisseur de 62 µm, comme pour le système selon l'invention.

Une comparaison est également effectuée avec une couche de PET de 162 µm d'épaisseur.

Les résultats sont donnés dans le tableau ci-dessous :

| | PET seul (comparatif) | PET-DELO-PET (comparatif) | PET -Ex.1-PET (invention) |
|---|---|---|---|
| Epaisseur (en µm) | 162 | 50-62-50 | 50-62-50 |
| WVTR (en q/m²/j) | 2,1 | 2,6 | 4,5 |
| TL (en h) | 4 | 47 | 136,5 |
| Rapport Dsec/Dhum | 0,4 | 6,6 | 33,8 |

On constate que l'invention permet d'augmenter considérablement le TL et donc de retarder l'équilibre.

### Exemple 6 - mesures de perméation (polymère de l'exemple 3)

On étudie de la même façon qu'à l'exemple 5 la perméabilité d'un système composé d'un substrat PET d'épaisseur 50 µm sur lequel a été déposé une couche de 47 µm d'épaisseur du polymère de l'exemple 3 en solution dans l'éthylène glycol (48 % en masse), recouverte d'un autre substrat PET de 50 µm, et sans séchage du solvant.

Une comparaison est effectuée avec une couche de PET de 147 µm d'épaisseur.

Les résultats sont donnés dans le tableau ci-dessous :

| | PET seul (comparatif) | PET -Ex.3-PET (invention) |
|---|---|---|
| Epaisseur (en µm) | 147 | 50-47-50 |
| WVTR (en g/m²/j) | 2,3 | 4,1 |
| TL (en h) | 3,3 | 404 |

A nouveau, on constate que l'invention permet d'augmenter considérablement le TL et donc de retarder l'équilibre.

### Exemple 7 - mesures de transparence (polymère de l'exemple 1)

On effectue des mesures de transmittance sur un spectrophotomètre UV-visible.

La transmittance d'un échantillon de PET d'épaisseur 50 µm sur le domaine de 250 à 900 nm est inférieure de 0,8 % à celle d'un échantillon PET-Ex.1-PET (50 µm - 26 µm - 50 µm), ce qui démontre la totale transparence de la composition de l'invention.

Après une exposition de 1700 h sous illumination continue (un soleil 1000 W/m² avec un spectre AM1.5), la perte de transmittance observée est de l'ordre de 0,3 % seulement sur le domaine de 400 à 800 nm, ce qui démontre la bonne résistance au vieillissement de l'invention sous illumination.

### Exemple 8 - caractérisation mécanique (polymère de l'exemple 1)

On prépare des échantillons sous la forme d'un disque de 7 cm de diamètre, à partir des systèmes suivants : substrat PET seul d'épaisseur 175 µm, multicouches PET-DELO-PET et PET-Ex.1-PET décrits à l'exemple 5. On appelle d la distance séparant deux extrémités diamétralement opposées de l'échantillon, et F la force appliquée sur une de ces deux extrémités pour la rapprocher de la seconde. Un point A du bord de l'échantillon est maintenu (par un serre-joint) à un support fixe. Un fil résistant est fixé sur un point B diamétralement opposé au point A ; ce fil passe par un trou effectué dans l'échantillon au point A puis est relié à une masse variable. Ce dispositif permet de faire varier la force appliquée sur le point B tout en imposant la direction du repliement de B vers A. La distance d correspond à la distance AB.

Les résultats sont donnés dans le tableau ci-dessous :

| | PET seul (comparatif) | PET-DELO-PET (comparatif) | PET -Ex.1-PET (invention) |
|---|---|---|---|
| Epaisseur (en µm) | 175 | 50-62-50 | 50-62-50 |
| F (en N) pour d = 3,4 cm | 700,5 | 460 | 49,5 |
| F (en N) pour d = 1,8 cm | 833,5 | 561 | 114,5 |

On constate que l'échantillon préparé conformément à l'invention présente une souplesse remarquable.

### Exemple 9 - encapsulation de dispositif photovoltaïque (polymère de l'exemple 1)

Un dispositif photovoltaïque organique est préalablement recouvert d'une couche planarisante d'environ 2 µm d'épaisseur à base de polymère fluoré comme décrit dans la demande de brevet n° FR 16/58014 déposée le 29 août 2016.

Une couche de polymère de l'exemple 1 d'une épaisseur de 26 µm est déposée sur le substrat d'un film barrière 3M^{®} UBF510 en suivant la même méthode que dans l'exemple 4. Le matériau résultant est laissé 2 h à l'air libre, puis séché 10 min à 70°C sous vide. Une goutte de colle ARKEMA^{®} AEC-Polymers F15 photo-polymérisable est placée au centre du système constitué par le substrat UBF510 enduit du polymère de l'exemple 1, puis elle est étalée sur une surface correspondant à la taille du dispositif photovoltaïque à encapsuler.

Ce dernier est placé sur la colle F15, puis recouvert d'une seconde goutte de colle F15 étalée de la même façon. De manière identique à ce qui a été décrit ci-dessus, un système substrat UBF510 enduit du polymère de l'exemple 1 est laminé manuellement sur la préparation précédente. L'ensemble est placé sous illumination UV dans un four UV KEOL à lampe de mercure basse pression pendant 2 min sur chaque face, pour permettre la réticulation de la colle F15.

On éclaire le dispositif photovoltaïque branché sur des circuits électriques avec une lampe de sorte à pouvoir mesurer la tension et le courant (I) ou la densité de courant (J). L'illumination est de 1000 W/m² avec un spectre AM1.5. On détermine la courbe de courant (I ou J) du dispositif en fonction de la tension.

On caractérise le dispositif en déterminant :
- sa tension circuit ouvert, ou tension à courant nul (Voc) ;
- sa densité de courant en court-circuit, ou densité de courant à tension nulle (Jsc) ;
- son facteur de forme (FF) égal à Pmax/(Voc × Jsc), où Pmax représente la puissance maximale fournie par le dispositif, c'est-à-dire le point de la courbe courant-potentiel pour lequel le produit V × J est le plus élevé ; et
- son efficacité de conversion d'énergie PCE = Voc × Jsc × FF / Pi, où Pi désigne la puissance incidente fournie par la lampe au dispositif.

Les résultats sont donnés dans le tableau ci-dessous :

| | Voc (mV) | Jsc (mA/cm²) | FF (%) | PCE (%) |
|---|---|---|---|---|
| Avant encapsulation | 504 | 9,20 | 45,8 | 2,12 |
| Après encapsulation | 491 | 9,22 | 44,8 | 2,03 |
| Variation | -2,6 % | +0,2 % | -2,2 % | -4,2 % |

On constate donc que l'invention permet une encapsulation efficace de dispositifs optoélectroniques, avec notamment une perte en rendement inférieure à 5%.

Dans un second temps, on procède à un vieillissement accéléré des dispositifs photovoltaïques organiques, en les plaçant dans une enceinte climatique suivant un cycle de 12 h à 40°C et 95 % d'humidité, puis 12 h à 20°C et 50 % d'humidité.

Après 4 cycles, le PCE est réduit de 69 % pour le dispositif photovoltaïque non encapsulé, et seulement de 8 % pour le dispositif photovoltaïque encapsulé.

L'invention offre donc une très bonne résistance au vieillissement.

### Exemple 10 - encapsulation de dispositif photovoltaïque (polymère de l'exemple 2)

La dispersion liquide (latex) de l'exemple 2 est concentrée par simple chauffage jusqu'à obtenir un extrait à sec de 44 % en masse. A l'aide d'une seringue munie d'un filtre à 5 µm, on prélève 3 mL de la dispersion que l'on dépose au centre d'un échantillon de film barrière 3M^{®} UBF510 (8 cm × 8 cm × 200 µm) préalablement traité UV/ozone pendant 10 minutes, et sur lequel on a préalablement déposé un cache, permettant de ne pas déposer la composition de l'invention dans les zones centrales 7 et 1 (conformément à la **figure 2****)** correspondant au futur emplacement du dispositif photovoltaïque et de la région adjacente.

L'échantillon est placé en rotation à 1000 tours/min ; cette vitesse est atteinte au bout de 7 s puis maintenue durant 23 s. Le matériau résultant est placé dans une étuve à 70°C sous vide pendant 2 h pour séchage. Après retrait du cache on obtient donc un film barrière 3M^{®} UBF510 comportant un dépôt de la composition uniquement dans les zones périphériques 3 et 8 (conformément à la **figure 2****).**

Une goutte de colle ARKEMA^{®} AEC-Polymers F15 photo-polymérisable est placée au centre du système constitué par le substrat UBF510 enduit du polymère, puis elle est étalée sur une surface correspondant aux centrales zones 7 et 1.

Un dispositif photovoltaïque organique est placé sur la colle F15, puis recouvert d'une seconde goutte de colle F15 étalée de la même façon. De manière identique à ce qui a été décrit ci-dessus, un système substrat UBF510 enduit du polymère de l'exemple 2 dans les zones 3 et 8 uniquement est laminé manuellement sur la préparation précédente. L'ensemble est placé sous illumination UV dans un four UV KEOL à lampe de mercure basse pression pendant 2 min sur chaque face, pour permettre la réticulation de la colle F15.

Dans un second temps, on procède à un vieillissement accéléré du dispositif photovoltaïque organique ainsi encapsulé, en le plaçant dans une enceinte climatique suivant un cycle de 12 h à 45°C et 85 % d'humidité, puis 12 h à 45°C et 15 % d'humidité. Le tableau ci-dessous présente le PCE normalisé c'est-à-dire PCE(t)/PCE(t=0) pour un dispositif ayant une encapsulation structurée comme décrit précédemment, et à titre de comparaison un dispositif encapsulé avec l'adhésif de référence DELO^{®} Katiobond^{®} LP655 et un dispositif non encapsulé.

| | Encapsulation selon l'invention | Encapsulation comparative | Dispositif non encapsulé |
|---|---|---|---|
| PCE normalisé à t = 48h | 0,94 | 0,96 | 0,4 |
| PCE normalisé à t = 336h | 1,00 | 1,02 | 0,05 |

L'invention offre donc une très bonne résistance au vieillissement, comparable à celle de la référence, mais avec la flexibilité en plus.

### Exemple 11 - mesures d'adhésion (polymère de l'exemple 2)

On fabrique comme décrit à l'exemple 4 un système composé d'un substrat PET de 50 µm d'épaisseur sur lequel est déposée une couche de 30 µm d'épaisseur de polymère de l'exemple 2 sec, recouverte d'un autre substrat PET de 50 µm d'épaisseur.

Cet échantillon est découpé sous forme d'éprouvette de 2 cm de largeur et de 7 cm de longueur (5 cm comportant le dépôt + 2 cm avec uniquement les deux substrats PET). Un test de pelage en T est réalisé pour étudier les propriétés d'adhésion en fonction de la fraction massique en eau de l'invention. La fraction massique en eau de l'invention correspond à la teneur massique en véhicule liquide dans la composition déposée à l'instant de la mesure. Le test de pelage consiste à fixer des mors sur chacun des PET dans la zone qui ne comporte pas de dépôts puis à éloigner ces mors progressivement à une vitesse constante de 100 mm/min et à mesurer la force nécessaire avant de la rapporter à la largeur des dépôts de 2 cm.

On constate que l'adhésion est relativement faible (F < 1 N/cm) à des fractions massiques en eau inférieures à 2 % ou supérieures à 16 %. Le maximum d'adhésion est atteint pour une fraction massique proche de 5 %, avec une valeur de 3,1 N/cm.

## Revendications

1. Utilisation d'une composition comprenant un polymère P qui comprend des unités issues d'au moins un monomère insaturé cationique pour la protection d'un dispositif électronique, dans laquelle le dispositif électronique comprend au moins un composant électronique et éventuellement un substrat sur lequel le composant électronique est disposé, ainsi qu'une structure encapsulante, la composition étant présente sous forme de couche dans la structure encapsulante.

2. Utilisation selon la revendication 1, dans laquelle le monomère insaturé cationique est un monomère de formule (I) : 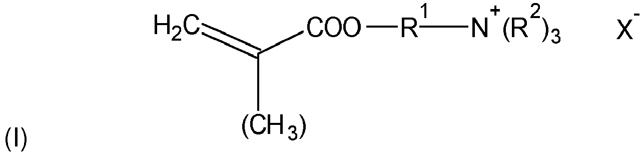
dans laquelle R¹ représente un groupement hydrocarboné divalent en C1 à C6, de préférence de C2 à C4, chaque groupe R² est indépendamment un groupement alkyle en C1 à C6, de préférence en C1 à C3, et X⁻ est un anion monovalent, de préférence un anion halogénure, et de préférence encore un anion bromure ou chlorure ; ledit monomère insaturé cationique étant de manière plus particulièrement préférée choisi parmi le chlorure d'acryloyloxyéthyltriméthylammonium et le chlorure de méthacryloyloxyéthyltriméthylammonium; et ledit monomère insaturé cationique étant de manière encore plus préférée le chlorure d'acryloyloxyéthyltriméthylammonium ;
et/ou dans laquelle la proportion massique d'unités issues de monomères insaturés cationiques dans le polymère P vaut de 50 à 100 %, de préférence de 70 à 90 %.

3. Utilisation selon la revendication 1 ou 2, dans laquelle le polymère P est réticulé, et de préférence le polymère P comprend des unités issues du triméthylolpropane triacrylate, du **N,N**-méthylène-bis(méth)acrylamide, du N-méthylol(méth)acrylamide et/ou du (poly)éthylèneglycol-diméthacrylate ;
et/ou dans laquelle le polymère P est un copolymère comprenant des unités issues d'au moins un monomère insaturé non ionique, de préférence choisi parmi les monomères (méth)acryliques, de préférence encore parmi les esters (méth)acryliques tels que le méthacrylate de méthyle et l'acrylate de butyle.

4. Utilisation selon l'une des revendications 1 à 3, dans laquelle la composition comprend en outre des particules d'un polymère P' non hydrosoluble, ledit polymère P' comprenant de préférence des unités issues d'un ou plusieurs monomères choisis parmi les monomères (méth)acryliques et notamment les esters (méth)acryliques tels que le méthacrylate de méthyle et l'acrylate de butyle, le styrène et ses dérivés, l'acétate de vinyle, l'acrylonitrile et les combinaisons de ceux-ci, la proportion relative pondérale de polymère P' par rapport à la somme du polymère P et du polymère P' étant de préférence de 10 à 60 %, de préférence encore de 20 à 40 % ;
et/ou dans laquelle la composition comprend une charge inorganique, de préférence choisie parmi le carbonate de calcium, l'oxyde de titane, les zéolithes, les boehmites, les polysilicates et les mélanges de ceux-ci, la teneur massique de la charge inorganique dans la composition étant de préférence de 1 à 50 %, de préférence encore de 2 à 20 % ;
et/ou dans laquelle la composition comprend un véhicule liquide, de préférence de l'eau et/ou un alcool, et de préférence dans une teneur massique de 2 à 50 %, de préférence encore de 5 à 35 %.

5. Utilisation selon l'une des revendications 1 à 4, pour la protection d'un dispositif électronique contre les agressions d'origine physico-chimiques, et de préférence contre la dissolution, la corrosion et l'oxydation, notamment dues à l'eau ou au dioxygène.

6. Utilisation selon l'une des revendications 1 à 5, dans laquelle le dispositif électronique est choisi parmi les transistors, les puces, les batteries, les cellules photovoltaïques, les diodes électroluminescentes, les diodes électroluminescentes organiques, les capteurs, les actionneurs, les transformateurs et les photodétecteurs ; et de préférence est un dispositif optoélectronique, et de manière encore plus préférée une diode électroluminescente organique ou une cellule photovoltaïque organique.

7. Dispositif électronique comprenant au moins un composant électronique, éventuellement un substrat sur lequel le composant électronique est disposé, et une structure encapsulante comprenant au moins une couche de la composition décrite dans l'une des revendications 1 à 4 ; la couche de la composition étant de préférence disposée au-dessus et/ou en dessous du composant électronique et/ou du substrat éventuel, soit directement en contact avec le composant électronique et/ou le substrat, soit sur une couche intermédiaire, qui est de préférence une couche de planarisation et/ou une couche d'adhésif ; et/ou la structure encapsulante comprenant de préférence une ou plusieurs couches de la composition disposées à distance et autour, mais non au-dessus ou en dessous, du composant électronique et/ou du substrat.

8. Dispositif électronique selon la revendication 7, dans lequel la structure encapsulante comprend au moins un film barrière aux gaz, de préférence deux films barrières aux gaz, de part et d'autre du composant électronique et le cas échéant du substrat, et au moins une couche de la composition disposée entre les deux films barrières aux gaz.

9. Dispositif électronique selon la revendication 7 ou 8, qui est choisi parmi les transistors, les puces, les batteries, les cellules photovoltaïques, les diodes électroluminescentes, les diodes électroluminescentes organiques, les capteurs, les actionneurs, les transformateurs et les photodétecteurs ; et qui de préférence est un dispositif optoélectronique, et de manière encore plus préférée une diode électroluminescente organique ou une cellule photovoltaïque organique.

10. Appareil comprenant un ou plusieurs dispositifs électroniques selon l'une des revendications 7 à 9, qui est de préférence choisi parmi les téléviseurs, les téléphones portables, les écrans rigides, les écrans flexibles, les modules photovoltaïques, les sources d'éclairage, les capteurs et les convertisseurs d'énergie.

11. Procédé de fabrication d'un dispositif électronique selon l'une des revendications 7 à 9, comprenant la fourniture d'un composant électronique, éventuellement disposé sur un substrat, et la formation d'une structure encapsulante, comprenant au moins une étape de dépôt d'une couche de la composition décrite dans l'une des revendications 1 à 4.

12. Procédé selon la revendication 11, comprenant le dépôt d'une couche de la composition directement sur le composant électronique et/ou le substrat ; et/ou comprenant le dépôt d'au moins une couche intermédiaire, qui est de préférence une couche de planarisation et/ou une couche d'adhésif, sur le composant électronique et/ou le substrat, puis le dépôt d'une couche de la composition sur cette couche intermédiaire.

13. Procédé selon la revendication 11 ou 12, comprenant :
- la fourniture d'un film barrière aux gaz, et la fixation de l'ensemble du composant électronique et du substrat éventuel sur celui-ci ; ou
- de préférence, la fourniture de deux films barrières aux gaz, et la fixation de l'ensemble du composant électronique et du substrat éventuel entre ceux-ci ;
et dans lequel de préférence:
- une couche de la composition est déposée sur tout ou partie du composant électronique et/ou du substrat avant la fixation ; et/ou
- une couche de la composition est déposée sur tout ou partie du ou des films barrières aux gaz avant la fixation, cette couche de la composition étant de préférence déposée sur une ou plusieurs zones du ou des films barrières aux gaz non destinées à venir en contact avec le composant électronique et/ou le substrat.

14. Procédé selon l'une des revendications 11 à 13, dans lequel la composition comprend un véhicule liquide, de préférence de l'eau et/ou un alcool, et le procédé comprend une étape d'évaporation du véhicule liquide après le dépôt de couche de composition, à l'issue de laquelle la teneur massique en véhicule liquide dans la composition est de préférence de 2 à 50 %, de préférence encore de 5 à 35 %.

## Patentansprüche

1. Verwendung einer Zusammensetzung, umfassend ein Polymer P, das Einheiten umfasst, die aus mindestens einem kationischen ungesättigten Monomer stammen, zum Schutz eines elektronischen Geräts, wobei das elektronische Gerät mindestens eine elektronische Komponente und eventuell ein Substrat umfasst, auf dem die elektronische Komponente angeordnet ist, sowie eine verkapselnde Struktur, wobei die Zusammensetzung in Form einer Schicht in der verkapselnden Struktur vorhanden ist.

2. Verwendung nach Anspruch 1, wobei das kationische ungesättigte Monomer ein Monomer der folgenden Formel (1) ist: 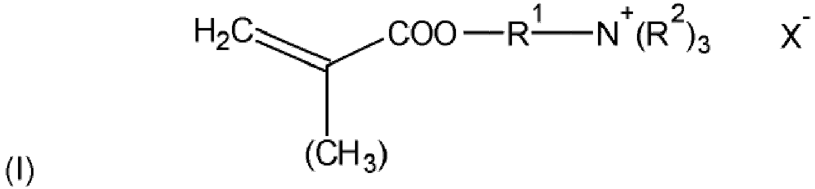
wobei R¹ eine bivalente Kohlenwasserstoffgruppe mit C1 bis C6, vorzugsweise mit C2 bis C4 darstellt, jede Gruppe R² unabhängig eine Alkylgruppe mit C1 bis C6, vorzugsweise C1 bis C3 ist, und X⁻ ein monovalentes Anion, vorzugsweise ein Halogenidanion und noch bevorzugter ein Bromidanion oder Chloridanion ist; wobei das kationische ungesättigte Monomer noch bevorzugter ausgewählt ist aus Acryloyloxyethyltrimethylammoniumchlorid und Methacryloyloxyethyltrimethylammoniumchlorid; und wobei das kationische ungesättigte Monomer noch bevorzugter Acryloyloxyethyltrimethylammoniumchlorid ist;
und/oder wobei der Massenanteil von Einheiten, die aus den kationischen ungesättigten Monomeren stammen, im Polymer P einen Wert von 50 bis 100 %, vorzugsweise von 70 bis 90 % aufweist.

3. Verwendung nach Anspruch 1 oder 2, wobei das Polymer P vernetzt ist und vorzugsweise das Polymer P Einheiten umfasst, die aus Trimethylolpropantriacrylat, N, N-Methylen-bis(meth)acrylamid, N-Methylol(meth)acrylamid und/oder Poly(ethylenglycol)dimethacrylat stammen;
und/oder wobei das Polymer P ein Copolymer ist, umfassend Einheiten, die aus mindestens einem nicht ionischen ungesättigten Monomer stammen, vorzugsweise ausgewählt aus (Meth)acrylmonomeren, noch bevorzugter aus (Meth)acrylestern wie z. B. Methylmethacrylat oder Butylmethacrylat.

4. Verwendung nach einem der Ansprüche 1 bis 3, wobei die Zusammensetzung außerdem Partikel eines nicht wasserlöslichen Polymers P' umfasst, wobei das Polymer P' vorzugsweise Einheiten umfasst, die aus einem oder mehreren Monomeren stammen, ausgewählt aus (Meth)acrylmonomeren und insbesondere (Meth)acrylestern wie z. B. Methylmethacrylat oder Butylmethacrylat, Styrol und seinen Derivaten, Vinylacetat, Acrylnitril und den Kombinationen derselben, wobei der relative Gewichtsanteil von Polymer P' mit Bezug auf die Summe von Polymer P und Polymer P' vorzugsweise 10 bis 60 %, noch bevorzugter von 20 bis 40 % ist;
und/oder wobei die Zusammensetzung eine anorganische Ladung umfasst, vorzugsweise ausgewählt aus Kalziumcarbonat, Titandioxid, Zeolithen, Böhmiten, Polysilikaten und den Mischungen derselben, wobei der Massengehalt der anorganischen Ladung in der Zusammensetzung vorzugsweise von 1 bis 50 %, noch bevorzugter von 2 bis 20 % ist;
und/oder wobei die Zusammensetzung einen flüssigen Träger umfasst, vorzugsweise Wasser und/oder Alkohol, und vorzugsweise in einem Massengehalt von 2 bis 50 %, noch bevorzugter von 5 bis 35 %.

5. Verwendung nach einem der Ansprüche 1 bis 4 zum Schutz eines elektronischen Geräts gegen physisch-chemische Aggressionen und vorzugsweise gegen Auflösung, Korrosion und die Oxydation, insbesondere aufgrund von Wasser oder Disauerstoff.

6. Verwendung nach einem der Ansprüche 1 bis 5, wobei das elektronische Gerät ausgewählt ist aus Transistoren, Chips, Batterien, Solarzellen, Leuchtdioden, organischen Leuchtdioden, Sensoren, Aktuatoren, Transformatoren und Fotodetektoren; und vorzugsweise ein optoelektronisches Gerät ist und noch bevorzugter eine organische Leuchtdiode oder eine organische Solarzelle ist.

7. Elektronisches Gerät, umfassend mindestens eine elektronische Komponente, eventuell ein Substrat, auf dem die elektronische Komponente angeordnet ist, und eine einkapselnde Struktur, umfassend mindestens eine Schicht der Zusammensetzung, die in den Ansprüchen 1 bis 4 beschrieben ist; wobei die Schicht der Zusammensetzung vorzugsweise über und/oder unter der elektronischen Komponente und/oder des eventuellen Substrats angeordnet ist, entweder direkt in Kontakt mit der elektronischen Komponente und/oder dem Substrat oder auf einer Zwischenschicht, die vorzugsweise eine Planarisierungsschicht und/oder eine haftende Schicht ist; und/oder wobei die einkapselnde Schicht vorzugsweise eine oder mehrere Schichten der Zusammensetzung umfasst, die in Abstand und um die/das, jedoch nicht über oder unter der elektronischen Komponente und/oder dem Substrat angebracht sind.

8. Elektronisches Gerät nach Anspruch 7, wobei die einkapselnde Struktur mindestens eine Gassperrfolie, vorzugsweise zwei Gassperrfolien auf beiden Seiten der elektronischen Komponente und gegebenenfalls des Substrats umfasst, und mindestens eine Schicht der Zusammensetzung zwischen den zwei Gassperrfolien angeordnet ist.

9. Elektronisches Gerät nach Anspruch 7 oder 8, das ausgewählt ist aus Transistoren, Chips, Batterien, Solarzellen, Leuchtdioden, organischen Leuchtdioden, Sensoren, Aktuatoren, Transformatoren und Fotodetektoren; und das vorzugsweise ein optoelektronisches Gerät ist und noch bevorzugter eine organische Leuchtdiode oder eine organische Solarzelle.

10. Gerät, umfassend ein oder mehrere elektronische Geräte nach einem der Ansprüche 7 bis 9, das vorzugsweise ausgewählt ist aus Fernsehgeräten, tragbaren Telefonen, starren Bildschirmen, flexiblen Bildschirmen, Solarmodulen, Leuchtquellen Sensoren und Energiewandlern.

11. Verfahren zur Herstellung eines elektronischen Geräts nach einem der Ansprüche 7 bis 9, umfassend Liefern einer elektronischen Komponente, eventuell angeordnet auf einem Substrat, und Bilden einer einkapselnden Struktur, umfassend mindestens einen Schritt des Ablegens einer Schicht der Zusammensetzung, die in den Ansprüchen 1 bis 4 beschrieben ist.

12. Verfahren nach Anspruch 11, umfassend Ablegen einer Schicht der Zusammensetzung direkt auf der elektronischen Komponente und/oder dem Substrat; und/oder umfassend Ablegen mindestens einer Zwischenschicht, die vorzugsweise eine Planarisierungsschicht und/oder eine haftende Schicht ist, auf der elektronischen Komponente und/oder dem Substrat, dann Ablegen einer Schicht der Zusammensetzung auf dieser Zwischenschicht.

13. Verfahren nach Anspruch 11 oder 12, umfassend:
- Liefern einer Gassperrfolie und Befestigen der Einheit des elektronischen Komponente und des eventuellen Substrats auf derselben; oder
- vorzugsweise Liefern von zwei Gassperrfolien und Befestigen der Einheit der elektronischen Komponente und des eventuellen Substrats zwischen denselben;
und wobei vorzugsweise:
- eine Schicht der Zusammensetzung auf der Gesamtheit oder einem Teil der elektronischen Komponente und/oder des Substrats vor dem Befestigen abgelegt ist; und/oder
- eine Schicht der Zusammensetzung auf der Gesamtheit oder einem Teil der Gassperrfolie(n) vor dem Befestigen abgelegt ist, wobei diese Schicht der Zusammensetzung vorzugsweise auf einer oder mehreren Zonen der Gassperrfolie(n) abgelegt ist, die nicht ausgelegt sind, um in Kontakt mit der elektronischen Komponente und/oder dem Substrat zu kommen.

14. Verfahren nach einem der Ansprüche 11 bis 13, wobei die Zusammensetzung einen flüssigen Träger umfasst, vorzugsweise Wasser und/oder einen Alkohol, und das Verfahren einen Schritt des Verdampfens des flüssigen Trägers nach dem Ablegen der Schicht der Zusammensetzung umfasst, an dessen Ausgang der Massengehalt an flüssigem Träger in der Zusammensetzung vorzugsweise von 2 bis 50 %, noch bevorzugter von 5 bis 35 % ist.

## Claims

1. Use of a composition comprising a polymer P having repeat units derived from at least one unsaturated cationic monomer, for the protection of an electronic device, wherein the electronic device comprises at least one electronic component and optionally a substrate on which the electronic component is arranged, and an encapsulating structure, the composition being in the form of a layer in the encapsulating structure.

2. The use according to claim 1, wherein the unsaturated cationic monomer is a monomer of formula (I): 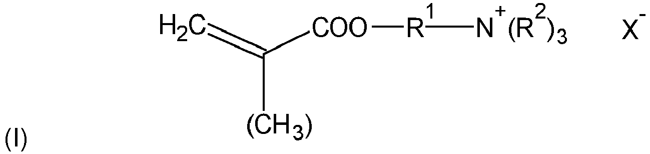
where R¹ is a C1 to C6 divalent hydrocarbon group, preferably C2 to C4, each R² group is independently a C1 to C6 alkyl group, preferably C1 to C3, and X⁻ is a monovalent anion, preferably a halide anion, and more preferably a bromide or chloride anion; said unsaturated cationic monomer being more particularly selected from among acryloyloxyethyltrimethylammonium chloride and methacryloyloxyethyltrimethylammonium chloride; and said unsaturated cationic monomer further preferably being acryloyloxyethyltrimethylammonium chloride;
and/or wherein the weight proportion of repeat units derived from unsaturated cationic monomers in polymer P is 50 to 100 %, preferably 70 to 90 %.

3. The use according to claim 1 or 2, wherein polymer P is crosslinked, and preferably polymer P comprises repeat units derived from trimethylolpropane triacrylate, N,N-methylene-bis(meth)acrylamide, N-methylol(meth)acrylamide and/or (poly)ethyleneglycol-dimethacrylate; and/or wherein polymer P is a copolymer comprising repeat units derived from at least one unsaturated nonionic monomer, preferably selected from among (meth)acrylic monomers, more preferably from among (meth)acrylic esters such as methyl methacrylate and butyl acrylate.

4. The use according to one of claims 1 to 3, wherein the composition also comprises particles of a non-water-soluble polymer P', said polymer P' preferably comprising repeat units derived from one or more monomers selected from among (meth)acrylic monomers and in particular (meth)acrylic esters such as methyl methacrylate and butyl acrylate, styrene and derivatives thereof, vinyl acetate, acrylonitrile and combinations thereof, the relative weight proportion of P' in relation to the sum of polymer P and polymer P' preferably being 10 to 60 %, more preferably 20 to 40 %;
and/or wherein the composition comprises an inorganic filler, preferably selected from among calcium carbonate, titanium oxide, zeolites, boehmites, polysilicates and mixtures thereof, the weight content of the inorganic filler in the composition preferably being from 1 to 50 %, more preferably 2 to 20 %;
and/or wherein the composition comprises a liquid carrier, preferably water and/or an alcohol, and preferably in a weight content of 2 to 50 %, more preferably 5 to 35 %.

5. The use according to one of claims 1 to 4, for the protection of an electronic device against attack of physicochemical origin, and preferably against dissolution, corrosion and oxidation particularly due to water or dioxygen.

6. The use according to one of claims 1 to 5, wherein the electronic device is selected from among transistors, chips, batteries, photovoltaic cells, light-emitting diodes, organic light-emitting diodes, sensors, actuators, transformers and photodetectors; preferably is an optoelectronic device and more preferably an organic light-emitting diode or organic photovoltaic cell.

7. An electronic device comprising at least one electronic component, optionally a substrate on which the electronic component is arranged, and an encapsulating structure comprising at least one layer of the composition described in one of claims 1 to 4; preferably wherein the layer of the composition is arranged above and/or below the electronic component and/or optional substrate, either directly in contact with the electronic component and/or substrate, or on an intermediate layer which is preferably a planarizing layer and/or adhesive layer; and/or preferably wherein the encapsulating structure comprises one or more layers of the composition arranged at a distance from and around, but not above or below, the electronic component and/or substrate.

8. The electronic device according to claim 7, wherein the encapsulating structure comprises at least one gas-barrier film, preferably two gas-barrier films on either side of the electronic component and optionally the substrate, and at least one layer of the composition arranged between the two gas-barrier films.

9. The electronic device according to claim 7 or 8, selected from among transistors, chips, batteries photovoltaic cells, light-emitting diodes, organic light-emitting diodes, sensors, actuators, transformers and photodetectors; and which is preferably an optoelectronic device and more preferably an organic light-emitting diode or organic photovoltaic cell.

10. An apparatus comprising one or more electronic devices according to one of claims 7 to 9, preferably selected from among television sets, mobile telephones, rigid screens, flexible screens, photovoltaic modules, lighting sources, sensors and energy converters.

11. A method for manufacturing an electronic device according to one of claims 7 to 9, comprising the providing of an electronic component, optionally arranged on a substrate, and the formation of an encapsulating structure, comprising at least one step to deposit a layer of the composition described in one of claims 1 to 4.

12. The method according to claim 11, comprising the deposition of a layer of the composition directly on the electronic component and/or substrate; and/or comprising the deposition of at least one intermediate layer which is preferably a planarizing layer and/or adhesive layer on the electronic component and/or substrate, followed by the deposition of a layer of the composition on this intermediate layer.

13. The method according to claim 11 or 12, comprising:
- providing a gas-barrier film, and attaching onto the latter the assembly of the electronic component and optional substrate; or
- preferably, providing two gas-barrier films and attaching therebetween the assembly of the electronic component and optional substrate;
and preferably wherein :
- a layer of the composition is deposited on all or part of the electronic component and/or substrate before attachment; and/or
- a layer of the composition is deposited on all or part of the gas-barrier film(s) before attachment, this layer of the composition preferably being deposited on one or more zones of the gas-barrier films not intended to come into contact with the electronic component and/or substrate.

14. The method according to one of claims 11 to 13, wherein the composition comprises a liquid carrier, preferably water and/or an alcohol, and the method comprises a step to evaporate the liquid carrier after depositing the layer of composition, after which the weight content of liquid carrier in the composition is preferably 2 to 50 %, more preferably 5 to 35 %.
